# FASCICULE DE BREVET EUROPEEN

(11) **EP 4 071 808 B1**
(45) Date de publication et mention de la délivrance du brevet: **04.10.2023**
(21) Numéro de dépôt: 22165545.9
(22) Date de dépôt: 30.03.2022
(51) Int. Cl.: H01L 25/07, H01L 29/778, H01L 29/417, H01L 29/20

(54) **ASSEMBLAGE ÉLECTRONIQUE POURVU D'UNE PLURALITÉ DE TRANSISTORS À HAUTE MOBILITÉ ÉLECTRONIQUE**
ELEKTRONISCHE BAUGRUPPE, DIE MIT EINER VIELZAHL VON TRANSISTOREN MIT HOHER ELEKTRONENBEWEGLICHKEIT VERSEHEN IST
ELECTRONIC ASSEMBLY PROVIDED WITH A PLURALITY OF TRANSISTORS WITH HIGH ELECTRON MOBILITY

(30) Priorité: 07.04.2021 FR 2103564
(43) Date de publication de la demande: 12.10.2022
(73) Titulaire: STMicroelectronics France, 92120 Montrouge (FR); STMicroelectronics International N.V., 1228 Plan-les-Ouates, Geneva (CH)
(72) Inventeur: NONGAILLARD, Matthieu, 38000 Grenoble (FR); OHEIX, Thomas, 38100 Grenoble (FR)
(74) Mandataire: Cabinet Beaumont

(56) Documents cités:
- US-A1- 2013 234 207
- US-A1- 2015 069 615
- US-A1- 2015 125 995

## Description

### Domaine technique

L'invention se rapporte au domaine de l'électronique, et notamment de l'électronique de puissance. Plus particulièrement, la présente invention concerne un assemblage électronique pourvu d'une pluralité de dispositifs électroniques formés de transistors à haute mobilité électronique.

L'assemblage électronique selon la présente invention est notamment agencé pour permettre une meilleure intégration de transistors à haute mobilité électronique.

L'agencement prévu dans la présente invention permet à cet égard l'obtention d'un assemblage compact et permettant d'obtenir une densité de courant plus élevée que celle susceptible de traverser un unique transistor à haute mobilité électronique.

### Technique antérieure

Les transistors à haute mobilité électronique (« HEMT » ou « High Electron Mobility Transistor » selon la terminologie Anglo-Saxonne), bien connus de l'homme du métier, sont aujourd'hui largement mis en œuvre dans le domaine des hyperfréquences et celui des commutateurs pour les convertisseurs en électronique de puissance.

A cet égard, ces transistors HEMT sont généralement élaborés à partir de couches de matériaux semi-conducteurs III-V et plus particulièrement des matériaux semi-conducteurs III-N.

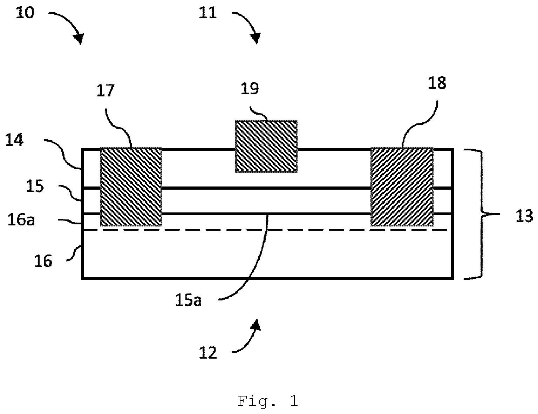

Notamment, la figure 1 représente un transistor HEMT 10 connu de l'état de la technique. Ce transistor HEMT 10 est pourvu d'un empilement 13 qui comprend, d'une face avant 11 vers une face arrière 12, une couche d'isolant 14, une couche barrière 15 et une couche canal 16 apte à former une couche de conduction 16a sous forme d'une couche de gaz électronique à deux dimensions. En particulier, la couche de conduction 16a s'étend dans la couche canal 16 à partir d'une interface 15a, formée entre la couche barrière 15 et ladite couche canal 16.

Les matériaux semi-conducteurs III-V choisis pour former la couche barrière 15 et/ou la couche canal 16 peuvent comprendre du nitrure de gallium (GaN), du nitrure d'aluminium (AlN), des alliages ternaires AlxGa1-xNx, de l'arséniure de gallium (GaAs), des alliages de ternaires d'AlGaAs ou d'InGaAs. Par exemple, la couche barrière 15 et la couche canal 16 peuvent comprendre, respectivement, un composé d'AlGaN et du GaN. La couche d'isolant 14 peut comprendre un matériau diélectrique et notamment du dioxyde de silicium (SiO2) ou nitrure de silicium (S13N4).

Le transistor HEMT 10 comprend également une électrode de source 17 et une électrode de drain 18 en contact électrique avec la couche de conduction 16a. Plus particulièrement, l'électrode de source 17 et l'électrode de drain 18 débouchent par la face avant 11, et traversent la couche d'isolant 14 et la couche barrière 15 afin d'atteindre l'interface 15a et contacter électriquement la couche de conduction 16a. L'électrode de source 17 et de l'électrode de drain 18 peuvent traverser partiellement ou intégralement la couche de conduction 16a. L'électrode de source 17 et l'électrode de 18 peuvent comprendre une espèce métallique, par exemple de l'aluminium, remplissant des tranchées formées dans l'empilement 13.

Le transistor HEMT 10 comprend également une électrode de grille 19 destinée à se voir imposer une tension Vg permettant de contrôler l'état de la couche de conduction 16a. Notamment, dès lors que la différence de potentiel électrique entre l'électrode de grille 19 et l'électrode de source 17, notée Vg-Vs (Vs étant la tension électrique de l'électrode de source), est supérieure à une tension de seuil Vth caractéristique du transistor HEMT 10, ledit transistor est dans l'état passant. A contrario, dès lors que Vg-Vs est inférieure à Vth, le transistor HEMT 10 est dans l'état non-passant, et se comporte donc comme un interrupteur ouvert.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Un tel transistor à haute mobilité électronique présente toutefois une résistivité Ron (Ron étant la résistance drain/source à l'état passant) à l'état passant qui limite l'intensité du courant susceptible de circuler dans la couche de conduction.

A cet égard, les principaux paramètres influençant la résistivité Ron sont :
- la résistance surfacique de la couche canal ;
- la résistance des contacts entre la couche de conduction et les électrodes de source et de drain ;
- les résistivités électriques des métaux de routage des puces ;
- les résistances électriques induites dans l'assemblage final dans lequel est intégré le transistor à haute mobilité électronique.

Afin de pallier ce problème, il est possible de réduire de manière significative la résistivité Ron d'un transistor à haute mobilité électronique en augmentant la surface de ce dernier. Il est néanmoins des situations pour lesquelles l'espace disponible pour l'intégration d'un transistor à haute mobilité électronique est contraint de sorte que telle solution ne puisse être envisagée.

De manière alternative, il peut être considéré d'optimiser les paramètres influençant la résistivité Ron. Une telle solution reste cependant complexe à mettre en oeuvre, car elle nécessite, d'une part, un redimensionnement complet du transistor à haute mobilité électronique, et d'autre part une revue du procédé permettant de fabriquer ledit transistor.

Par ailleurs, le document US 2015/069615 A1 montre un assemblage électronique qui s'étend selon une direction d'empilement d'une face inférieure vers une face supérieure reliées par une surface latérale. Cet assemblage comprend au moins deux modules élémentaires empilés selon la direction d'empilement qui comprennent chacun, selon la direction d'empilement et d'une face arrière vers une face avant, deux transistors à haute mobilité électronique ("HEMT" selon la terminologie Anglo-Saxonne), dits, respectivement, transistor arrière et transistor avant et ayant en commun une électrode de source.

Un but de la présente invention est donc de proposer un assemblage permettant une densité d'intégration de transistors à haute mobilité électronique plus importante sans toutefois augmenter de manière significative l'espace occupé par ledit dispositif.

Un autre but de la présente invention est de proposer un assemblage d'une pluralité de transistors à haute mobilité électronique agencés de manière à limiter l'échauffement dudit assemblage.

### Résumé de l'invention

La présente invention concerne un assemblage électronique selon la revendication 1. Cet assemblage s'étend selon une direction d'empilement d'une face inférieure vers une face supérieure reliées par une surface latérale, l'assemblage comprend au moins deux modules élémentaires empilés selon la direction d'empilement qui comprennent chacun, selon la direction d'empilement et d'une face arrière vers une face avant, deux transistors à haute mobilité électronique dits, respectivement, transistor arrière et transistor avant, séparés par une couche d'isolant, et ayant en commun une électrode de source, une électrode de drain et une électrode de grille, l'ensemble des transistors avants et arrières étant électriquement connectés en parallèle, l'assemblage électronique comprend, disposée sur la face avant de chaque module élémentaire, une couche contact, contactant électriquement l'électrode de grille du module élémentaire considéré par sa face avant, chacune des couches contact comprenant un point de contact électrique débouchant sur la surface latérale.

Selon un mode de mise en oeuvre, une couche contact intercalée entre deux modules élémentaires dits, selon la direction d'empilement, premier module et deuxième module, contacte également, par la face arrière du deuxième module, l'électrode de grille dudit deuxième module.

Selon un mode de mise en oeuvre, ledit assemblage électronique comprend des moyens de connexion source et de moyen de connexion drain agencés pour connecter en parallèle l'ensemble des transistors avant et des transistors arrière.

Selon un mode de mise en oeuvre, les moyens de connexion source comprennent des plots sources, chaque plot source étant intercalé entre deux modules élémentaires adjacents de manière à connecter électriquement les électrodes de source des modules élémentaires considérés.

Selon un mode de mise en oeuvre, les moyens de connexion drain comprennent des plots drains, chaque plot drain étant intercalé entre deux modules élémentaires adjacents de manière à connecter électriquement les électrodes de drain des modules élémentaires considérés.

Selon un mode de mise en oeuvre, le transistor avant et le transistor arrière comprennent, respectivement un empilement avant et un empilement arrière, l'empilement avant comprenant, de la couche d'isolant vers la face avant, une couche barrière avant et une couche canal avant, et l'empilement arrière comprenant de la couche d'isolant vers la face arrière une couche barrière arrière et une couche canal arrière, la couche canal avant et la couche canal arrière étant chacune aptes à former une couche de conduction sous forme d'un gaz d'électrons à deux dimensions.

Selon un mode de mise en oeuvre, l'empilement avant et l'empilement arrière sont essentiellement identiques.

Selon un mode de mise en oeuvre, les transistors avant et arrières présentent une tension de seuil identique.

Selon un mode de mise en oeuvre, la couche canal avant et la couche canal arrière comprennent du GaN et la couche barrière avant et la couche barrière arrière comprennent un alliage ternaire d'AlGaN.

Selon un mode de mise en oeuvre, la couche d'isolant comprend un matériau diélectrique, avantageusement, du dioxyde de silicium ou du nitrure de silicium.

Selon un mode de mise en oeuvre, la couche contact comprend un élément métallique, avantageusement l'élément métallique comprend du cuivre.

Selon un mode de mise en oeuvre, ledit assemblage comprend également une couche contact inférieure disposée sur la face arrière d'un module élémentaire, dit module inférieur, premier dans l'ordre des modules élémentaires selon la direction d'empilement, la couche contact inférieure est agencée pour contacter, par la face arrière, l'électrode de grille du module inférieur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique d'un transistor HEMT connu de l'état de la technique, notamment, le transistor HEMT est représenté selon un plan de coupe perpendiculaire à la face avant ;
la figure 2a est une représentation schématique, selon un plan de coupe longitudinal coupant la zone active, d'un assemblage électronique conforme à la présente invention ;
la figure 2b est une représentation schématique, selon un plan de coupe longitudinal en dehors de la zone active, d'un assemblage électronique conforme à la présente invention ;
la figure 3a est une représentation schématique d'un module élémentaire, selon un plan de coupe coupant la zone active, conforme à la présente invention ;
la figure 3b est une représentation schématique d'un module élémentaire, selon un plan de coupe en dehors de la zone active, conforme à la présente invention ;
la figure 4 est une représentation illustrant le positionnement déporté du plot grille permettant de connecter électriquement l'électrode de grille du module élémentaire de la figure 3a selon une vue par la face avant dudit dispositif.

### Description des modes de réalisation

Il est entendu que les différentes figures présentées en relation avec la présente description ne sont données qu'à titre d'illustration et ne limitent en aucune manière l'invention. Il est notamment clair que les échelles ou dimensions relatives peuvent ne pas être respectées.

Dans toute la description, il est admis qu'une couche ou une interface est généralement plane et s'étend selon un plan parallèle au plan (0, x, y) du repère orthonormé (0, x, y, z). Par ailleurs, dès qu'il est fait référence à une représentation selon un plan de coupe, ce dernier est perpendiculaire à l'ensemble des plans formés par les couches, et plus particulièrement perpendiculaire au plan (0, x, y). Il est également entendu que, dès lors qu'il est fait référence à un empilement de couches, ces dernières sont empilées selon la direction z du repère orthonormé (0, x, y, z) .

L'invention concerne un assemblage électronique qui s'étend selon une direction d'empilement d'une face inférieure vers une face supérieure reliées par une surface latérale. L'assemblage comprend notamment au moins deux modules élémentaires empilés selon la direction d'empilement qui comprennent chacun, selon la direction d'empilement et d'une face arrière vers une face avant, deux transistors à haute mobilité électronique dits, respectivement, transistor arrière et transistor avant, séparés par une couche d'isolant. Par ailleurs, au sein de chaque module élémentaire, le transistor avant et le transistor arrière ont en commun une électrode de source, une électrode de drain et une électrode de grille. En outre, l'ensemble des transistors avant et arrières sont électriquement connectés en parallèle. L'assemblage électronique comprend, disposée sur la face avant de chaque module élémentaire, une couche contact, contactant électriquement l'électrode de grille du module élémentaire considéré par sa face avant, chacune des couches contact comprenant un point de contact électrique débouchant sur la surface latérale.

Il est entendu qu'une direction d'empilement définit également un « sens ». Autrement dit, et dans le contexte de la présente invention, la direction d'empilement est orientée de la face inférieure vers la face supérieure ou de manière équivalente de la face arrière vers la face avant.

Conformément à la présente invention, des transistors connectés en parallèle sont des transistors pour lesquels les chemins de conduction sont parallèles. Plus particulièrement, l'ensemble des électrodes de sources des transistors sont connectées entre elles, et l'ensemble des électrodes de drains sont connectées entre elles.

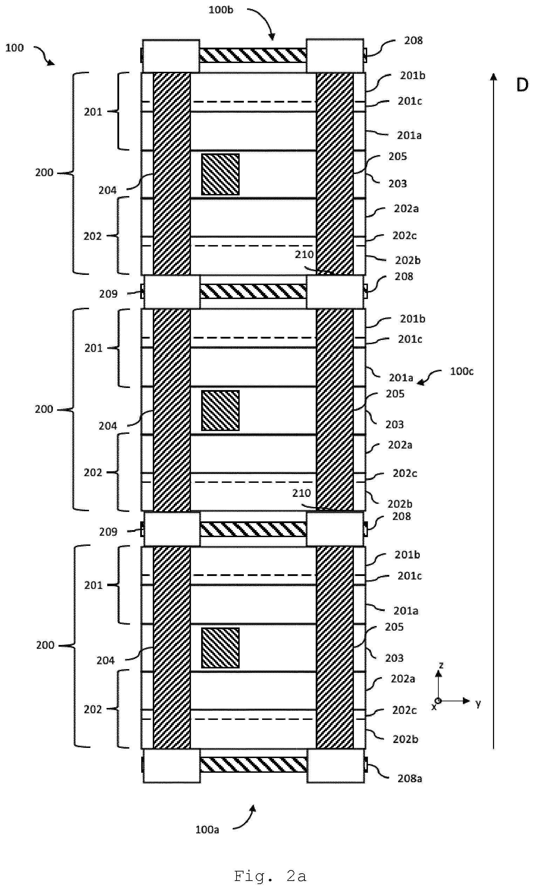

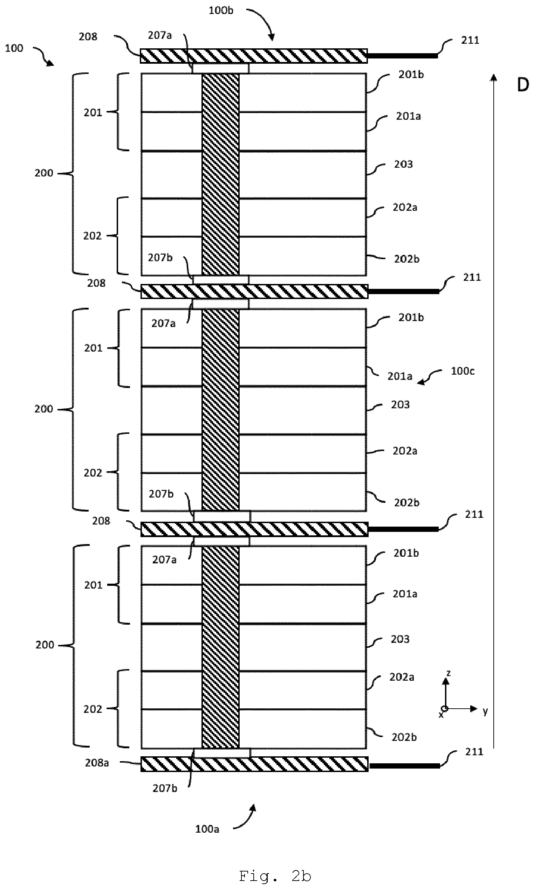

A la figure 2a et à la figure 2b, on peut voir des représentations schématiques selon un plan de coupe longitudinal d'un assemblage électronique 100 conforme à la présente invention.

L'assemblage électronique 100 s'étend notamment, selon une direction d'empilement D, d'une face inférieure 100a vers une face supérieure 100b. La face inférieure 100a et la face supérieure 100b sont reliées par une surface latérale 100c.

L'assemblage électronique 100 comprend un empilement d'au moins deux modules élémentaires 200 (notamment 3 modules élémentaires, figure 2a et figure 2b).

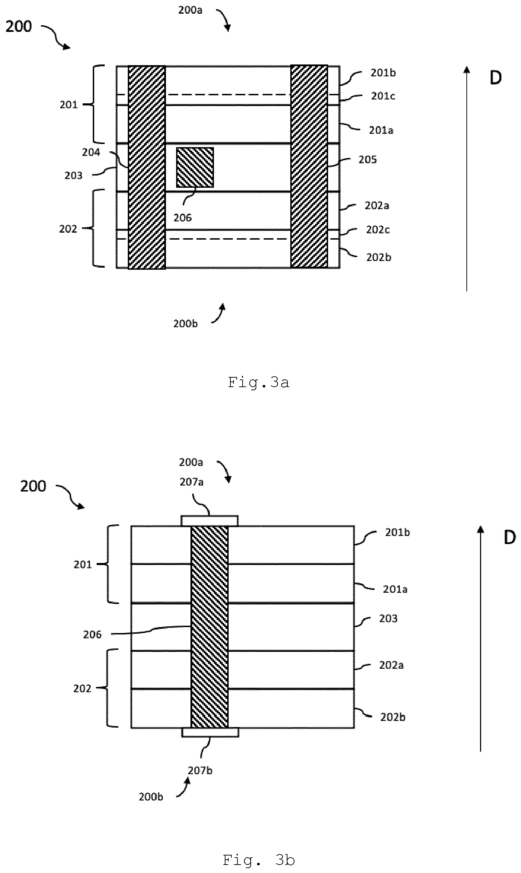

La figure 3a et la figure 3b représentent à cet égard un module élémentaire 200 selon les termes de la présente invention. Ce dernier comprend deux transistors à haute mobilité électronique (ci-après « transistor HEMT ») . Notamment, le module élémentaire 200 comprend, d'une face arrière 200b vers une face avant 200a, et selon la direction d'empilement D, un transistor arrière 202 et un transistor avant 201 séparés par une couche d'isolant 203. La couche d'isolant 203 peut avantageusement comprendre du dioxyde de silicium ou du nitrure de silicium.

Le transistor avant 201 et le transistor arrière 202 comprennent chacun un empilement dit, respectivement, empilement avant et empilement arrière. Chacun de ces empilements peut notamment comprendre des matériaux semi-conducteurs du groupe III-V, et plus particulièrement des matériaux semi-conducteurs du groupe III-N. Les matériaux semi-conducteurs du groupe III-V pourront notamment être choisis parmi le nitrure de gallium (GaN), le nitrure d'aluminium (AlN) et leurs alliages ternaires AlxGa1-xN, ou parmi l'arséniure de gallium (GaAs) et ses composés (AlGaAs, InGaAs) .

L'empilement avant et l'empilement arrière comprennent chacun une couche barrière et une couche canal. Notamment, l'empilement avant comprend, de la couche d'isolant 203 vers la face avant 200a, une couche barrière avant 201a et une couche canal avant 201b. De manière équivalente, l'empilement arrière comprend, de la couche d'isolant 203 vers la face arrière 200b, une couche barrière arrière 202a et une couche canal arrière 202b.

A titre d'exemple et selon la présente invention, une couche barrière peut comprendre un alliage ternaire d'AlxGa1-xN, tandis qu'une couche canal peut comprendre du GaN.

Par ailleurs, une couche barrière peut présenter une épaisseur comprise entre 1 nm et 100 nm. Une couche canal peut présenter une épaisseur comprise entre 10 nm et 2pm.

L'empilement avant et l'empilement arrière, selon les termes de la présente invention, sont chacun aptes à former une couche de gaz d'électrons à deux dimensions (2DEG pour « 2-dimensional electron gaz ») qui constitue une couche de conduction.

La couche de conduction, au sein d'un empilement, s'étend dans la couche canal, à partir de l'interface formée entre la couche barrière et la couche canal de l'empilement considéré.

Ainsi, l'empilement avant comprend une couche de conduction avant 201c qui s'étend dans la couche canal avant 201b, à partir d'une interface avant formée entre la couche barrière avant 201a et la couche canal avant 201b.

De manière équivalente, l'empilement arrière comprend une couche de conduction arrière 202c qui s'étend dans la couche canal arrière 202b, à partir d'une interface arrière formée entre la couche barrière arrière 202a et la couche canal arrière 202b.

Au sein d'un module élémentaire 200, le transistor avant 201 et le transistor arrière 202 ont en commun une électrode de source 204, une électrode de drain 205 et une électrode de grille 206.

En particulier, l'électrode de source 204 et l'électrode de drain 205 traversent la couche d'isolant 203, et s'étendent chacune de part et d'autre de ladite couche d'isolant 203 pour, chacune, contacter électriquement la couche de conduction avant 201c et la couche de conduction arrière 202c.

Tel qu'illustré à la figure 2a, l'assemblage comprend également des moyens de connexion source 209 et des moyens de connexion drain 210.

Notamment, chaque moyen de connexion source est intercalé entre deux modules élémentaires adjacents de manière à connecter électriquement entre elles leurs électrodes de source. Ainsi, l'ensemble des électrodes de source sont connectées entre elles.

De manière équivalente, chaque moyen de connexion drain 210 est intercalé entre deux modules élémentaires adjacents de manière à connecter électriquement entre elles leurs électrodes de drain. Ainsi, l'ensemble des électrodes de drain sont connectées entre elles.

Les moyens de connexion source et drain peuvent comprendre des plots, notamment des plots comprenant un matériau semi-conducteur dopé, par exemple du silicium dopé.

Les plots source et les plots drain peuvent être stratifiés et comprendre chacun un empilement, selon la direction d'empilement, de plots élémentaires.

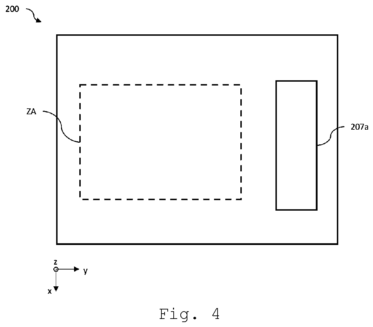

L'électrode de grille 206 s'étend selon la direction D, et reste à distance, dans une zone active ZA du module élémentaire, de l'une et l'autre de la couche de conduction avant 201c et de la couche de conduction arrière 202c. La zone active ZA est une zone délimitée d'un module élémentaire 200 dans laquelle la couche de conduction avant 201c et la couche de conduction arrière 202c sont susceptibles d'assurer une circulation du courant de l'électrode de source 204 vers l'électrode de drain 205. Cette zone active ZA (figure 4), en projection sur l'une et l'autre de la face avant 200a et de la face arrière 200b, peut prendre la forme d'un rectangle ou d'un carré. L'invention ne doit toutefois pas être limitée à cette seule considération et l'homme du métier, en fonction des contraintes qui sont susceptibles de lui être imposées, pourra considérer toute autre forme de zone active ZA.

En dehors de la zone active (figure 3b), l'électrode de grille 206 traverse intégralement l'empilement avant et l'empilement arrière.

Le module élémentaire 200 peut comprendre, en dehors de la zone active ZA, sur sa face avant 200a et sa face arrière 200b, respectivement, un plot grille avant 207a et, éventuellement, un plot grille arrière 207b (figure 2b et figure 3b). Le plot grille avant 207a et le plot grille arrière 207b sont notamment agencés pour permettre un contact électrique avec l'électrode de grille 206 par la face avant 200a et la face arrière 200b. Le plot grille avant 207a et le plot grille arrière 207b peuvent comprendre un matériau semi-conducteur dopé, par exemple du silicium dopé.

L'électrode de grille 206 est ainsi agencée pour piloter ou contrôler l'état de l'un et l'autre du transistor avant 201 et du transistor arrière 202. Notamment, ce contrôle est exécuté en imposant un potentiel électrique Vg à l'électrode de grille 206, et plus particulièrement une différence de potentiel électrique DDP, noté Vg-Vs entre l'électrode de grille 206 et l'électrode de source 204.

Ainsi, dès lors que Vg-Vs est supérieure à une tension de seuil Vth caractéristique de chacun des transistors 201 et 202, ces derniers sont dans l'état passant. A contrario, dès lors que Vg-Vs est inférieure à Vth, les transistors 201 et 202 sont dans l'état non-passant, et se comportent donc comme des interrupteurs ouverts.

De manière avantageuse, le transistor avant et le transistor arrière présentent une tension de seuil Vth identique.

Ainsi, lorsque le transistor avant 201 et le transistor arrière 202 sont dans l'état passant, le courant circulant entre l'électrode de source 204 et l'électrode de drain 205 emprunte deux chemins de conduction parallèles formés par la couche de conduction avant 201c et la couche de conduction arrière 202c.

La mise en oeuvre des moyens de connexion source et des moyens de connexion drain permet de mettre en parallèle l'ensemble des transistors avant et des transistors arrière. Ainsi, et selon cette architecture, dès lors que l'ensemble des transistors avant et arrières sont dans un état passant, les couches de conduction formées par ces derniers sont électriquement connectées en parallèle.

L'assemblage électronique 100 comprend également au moins un couche contact 208.

Notamment, chaque couche contact 208 est disposée sur la face avant d'un module élémentaire 200 de manière à contacter électriquement le plot grille avant 207a du module considéré. Chaque couche contact 208 est notamment configurée pour imposer un potentiel Vg à l'électrode de grille avec laquelle elle est en contact électrique. En d'autres termes, la couche contact 208 est configurée pour imposer le passage de l'un des états passant et non passant vers l'autre de ces deux états aux transistors avant et arrière du module élémentaire auquel est associé ladite couche contact.

Par ailleurs, une couche contact 208, dite première couche contact, reposant sur la face avant d'un module élémentaire donné, dit premier module, peut également être en contact avec l'électrode de grille d'un autre module élémentaire, dit deuxième module, immédiatement adjacent au premier module. Le contact entre la première couche contact et l'électrode de grille du deuxième module se faisant par la face arrière (notamment via le plot grille arrière 207b) dudit deuxième module.

Il est notable que la mise en oeuvre du plot grille avant 207a et du plot grille arrière 207b n'est pas strictement nécessaire. En d'autres termes, il est possible d'envisager un contact direct entre couche contact et électrode de grille.

Il est par ailleurs clair que l'empilement formé par l'ensemble des modules élémentaires est terminé selon la face supérieure par une des couches contact.

Une couche contact inférieure 208a peut également être considérée. Cette dernière est notamment disposée sur la face arrière d'un module élémentaire, dit module inférieur, premier dans l'ordre des modules élémentaires selon la direction d'empilement. Cette couche contact inférieure est notamment agencée pour contacter par la face arrière l'électrode de grille du module inférieur.

Ainsi, selon cet agencement, l'ensemble des transistors avant 201 et des transistors arrière 202 sont connectés en parallèle. En d'autres termes, dès lors que les transistors avant et les transistors arrière sont dans l'état passant, les couches de conduction avant et les couches de conduction arrière forment un ensemble de chemins de conduction parallèles.

Autrement dit, dès lors que la différence de potentiel Vg-Vs imposée entre les électrodes de grille et les électrodes de source est supérieure à la tension de seuil Vth, l'ensemble des transistors avant et des transistors arrière sont dans l'état passant.

Dans l'architecture proposée, et dans la mesure où les couches de conduction sont connectées en parallèle, il est possible de considérer la circulation d'une densité de courant plus importante que dans les dispositifs connus de l'état de la technique. En effet, si chacun des transistors avant et des transistors arrière présentent la même résistance Ron à l'état passant, la résistance à l'état passant Ron de l'assemblage électronique est égale à la résistance Ron/(2n), où n est le nombre de modules électroniques considérées.

En d'autres termes, il est possible, par simple empilement de transistors à haute mobilité électronique, d'obtenir un dispositif électronique de plus faible résistance à l'état passant sans avoir à modifier les caractéristiques géométriques desdits transistors.

Par ailleurs, selon la présente invention, les couches contact, et la couche contact inférieure (si elle est considérée) débouchent sur la surface latérale de l'assemblage électronique. Notamment, chacune des couches contact comprend un point de contact 211 sur la surface latérale. Cet agencement permet notamment d'imposer un potentiel Vg commun au niveau de chacun des points de contact 211 lorsqu'il s'agit de faire commuter l'ensemble des transistors avant et des transistors arrière de l'un de l'état passant et de l'état non passant vers l'autre de ces deux états. Cette architecture permet ainsi de limiter les problèmes d'échauffement si un seul point contact devait être considéré pour induire la commutation susmentionnée.

Enfin, les couches contact, généralement faites de métal et plus particulièrement de cuivre, jouent également le rôle de dissipateurs thermique.

Un tel assemblage électronique est avantageusement mis en oeuvre dès lors que de très forts courants sont requis. Notamment, l'assemblage électronique selon la présente invention est avantageusement mis en oeuvre dans un convertisseur à très fort courant, dans des moteurs industriels, dans des presses, dans des rotatives d'imprimerie, dans des remontées mécaniques.

Bien sûr, l'invention n'est pas limitée aux modes de réalisation décrits et on peut y apporter des variantes de réalisation sans sortir du cadre de l'invention tel que défini par les revendications.

## Revendications

1. Assemblage électronique (100) qui s'étend selon une direction d'empilement d'une face inférieure (100a) vers une face supérieure (100b) reliées par une surface latérale (100c), l'assemblage comprend au moins deux modules élémentaires (200) empilés selon la direction d'empilement qui comprennent chacun, selon la direction d'empilement et d'une face arrière (200b) vers une face avant (200a), deux transistors à haute mobilité électronique dits, respectivement, transistor arrière (202) et transistor avant (201), séparés par une couche d'isolant (203), et ayant en commun une électrode de source (204), une électrode de drain (205) et une électrode de grille (206), l'ensemble des transistors avants et arrières étant électriquement connectés en parallèle, l'assemblage électronique (100) comprend, disposée sur la face avant (200a) de chaque module élémentaire, une couche contact (208), contactant électriquement l'électrode de grille (206) du module élémentaire considéré par sa face avant (200a), chacune des couches contact (208) comprenant un point de contact (211) électrique débouchant sur la surface latérale.

2. Assemblage électronique (100) selon la revendication 1, dans lequel, une couche contact (208) intercalée entre deux modules élémentaires (200) dits, selon la direction d'empilement, premier module et deuxième module, contacte également, par la face arrière (200b) du deuxième module, l'électrode de grille (206) dudit deuxième module.

3. Assemblage électronique (100) selon la revendication 1 ou 2, dans lequel ledit assemblage électronique (100) comprend des moyens de connexion source et de moyen de connexion drain agencés pour connecter en parallèle l'ensemble des transistors avant et des transistors arrière (202).

4. Assemblage électronique (100) selon la revendication 3, dans lequel les moyens de connexion source comprennent des plots sources (209), chaque plot source (209) étant intercalé entre deux modules élémentaires adjacents de manière à connecter électriquement les électrodes de source des modules élémentaires considérés.

5. Assemblage électronique (100) selon la revendication 3 ou 4, dans lequel les moyens de connexion drain comprennent des plots drains (210), chaque plot drain étant intercalé entre deux modules élémentaires adjacents de manière à connecter électriquement les électrodes de drain des modules élémentaires considérés.

6. Assemblage électronique (100) selon l'une des revendications 1 à 5, dans lequel le transistor avant (201) et le transistor arrière (202) comprennent, respectivement un empilement avant et un empilement arrière, l'empilement avant comprenant, de la couche d'isolant (203) vers la face avant (200a), une couche barrière avant (201a) et une couche canal (201b) avant, et l'empilement arrière comprenant de la couche d'isolant (203) vers la face arrière (200b) une couche barrière arrière (202a) et une couche canal arrière (202b), la couche canal avant et la couche canal arrière étant chacune aptes à former une couche de conduction (201c, 202c) sous forme d'un gaz d'électrons à deux dimensions.

7. Assemblage électronique (100) selon la revendication 6, dans lequel l'empilement avant et l'empilement arrière sont essentiellement identiques.

8. Assemblage électronique (100) selon la revendication 6 ou 7, dans lequel les transistors avant et arrières présentent une tension de seuil identique.

9. Assemblage électronique (100) selon l'une des revendications 6 à 8, dans lequel la couche canal avant et la couche canal arrière comprennent du GaN et la couche barrière avant et la couche barrière arrière comprennent un alliage ternaire d'AlGaN.

10. Assemblage électronique (100) selon l'une des revendications 1 à 9, dans lequel la couche d'isolant (203) comprend un matériau diélectrique, avantageusement, du dioxyde de silicium ou du nitrure de silicium.

11. Assemblage électronique (100) selon l'une des revendications 1 à 10, dans lequel la couche contact (208) comprend un élément métallique, avantageusement l'élément métallique comprend du cuivre.

12. Assemblage électronique (100) selon l'une des revendications 1 à 11, dans lequel ledit assemblage comprend également une couche contact (208) inférieure disposée sur la face arrière (200b) d'un module élémentaire, dit module inférieur, premier dans l'ordre des modules élémentaires (200) selon la direction d'empilement, la couche contact (208) inférieure est agencée pour contacter, par la face arrière (200b), l'électrode de grille (206) du module inférieur.

## Patentansprüche

1. Elektronische Baugruppe (100), die sich entlang einer Stapelrichtung von einer Unterseite (100a) zu einer Oberseite (100b) erstreckt, die durch eine Seitenfläche (100c) gekoppelt sind, wobei die Baugruppe mindestens zwei Elementarmodule (200) aufweist, die entlang der Stapelrichtung gestapelt sind, die jeweils entlang der Stapelrichtung und von einer Rückseite (200b) zu einer Vorderseite (200a) zwei Transistoren mit hoher Elektronenbeweglichkeit aufweisen, die als hinterer Transistor (202) bzw. vorderer Transistor (201) bezeichnet werden, die durch eine Isolatorschicht (203) getrennt sind, und die gemeinsam eine Source-Elektrode (204), eine Drain-Elektrode (205) und eine Gate-Elektrode (206) aufweisen, wobei die Baugruppe aus vorderen und hinteren Transistoren elektrisch parallel geschaltet ist, wobei die elektronische Baugruppe (100) eine auf der Vorderseite (200a) jedes Elementarmoduls angeordnete Kontaktschicht (208) aufweist, die die Gate-Elektrode (206) des jeweiligen Elementarmoduls an seiner Vorderseite (200a) elektrisch kontaktiert, wobei jede der Kontaktschichten (208) einen elektrischen Kontaktpunkt (211) aufweist, der an der Seitenfläche heraustritt.

2. Elektronische Baugruppe (100) nach Anspruch 1, **dadurch gekennzeichnet, dass** eine Kontaktschicht (208), die sich zwischen zwei Elementarmodulen (200) befindet, die je nach Stapelrichtung als erstes Modul und zweites Modul bezeichnet werden, ebenfalls auf der Rückseite (200b) des zweiten Moduls die Gate-Elektrode (206) des zweiten Moduls kontaktiert.

3. Elektronische Baugruppe (100) nach Anspruch 1 oder 2, wobei die elektronische Baugruppe (100) Source-Verbindungsmittel und Drain-Verbindungsmittel aufweist, die so angeordnet sind, dass sie alle vorderen Transistoren und hinteren Transistoren (202) parallel schalten.

4. Elektronische Baugruppe (100) nach Anspruch 3, wobei die Source-Verbindungsmittel Source-Pads (209) aufweisen, wobei jedes Source-Pad (209) zwischen zwei benachbarten Elementarmodulen angeordnet ist, um die SourceElektroden der jeweiligen Elementarmodule elektrisch zu verbinden.

5. Elektronische Baugruppe (100) nach Anspruch 3 oder 4, wobei die Drain-Verbindungsmittel Drain-Pads (210) aufweisen, wobei jedes Drain-Pad zwischen zwei benachbarten Elementarmodulen angeordnet ist, um die Drain-Elektroden der jeweiligen Elementarmodule elektrisch zu verbinden.

6. Elektronische Baugruppe (100) nach einem der Ansprüche 1 bis 5, wobei der vordere Transistor (201) und der hintere Transistor (202) jeweils einen vorderen Stapel und einen hinteren Stapel aufweisen, wobei der vordere Stapel ausgehend von der Isolatorschicht (203) bis zur Vorderseite (200a) eine vordere Barriereschicht (201 a) und eine vordere Kanalschicht (201b) aufweist, und wobei der hintere Stapel ausgehend von der Isolatorschicht (203) zur Rückseite (200b) eine hintere Barriereschicht (202a) und eine hintere Kanalschicht (202b) aufweist, wobei die vordere Kanalschicht und die hintere Kanalschicht jeweils eine Leitungsschicht (201c, 202c) in Form eines zweidimensionalen Elektronengases bilden können.

7. Elektronische Anordnung (100) nach Anspruch 6, wobei der vordere Stapel und der hintere Stapel im Wesentlichen identisch sind.

8. Elektronische Baugruppe (100) nach Anspruch 6 oder 7, wobei der vordere und der hintere Transistor eine identische Schwellenspannung aufweisen.

9. Elektronische Baugruppe (100) nach einem der Ansprüche 6 bis 8, wobei die vordere Kanalschicht und die hintere Kanalschicht GaN aufweisen und die vordere Barriereschicht und die hintere Barriereschicht eine ternäre AlGaN-Legierung aufweisen.

10. Elektronische Baugruppe (100) nach einem der Ansprüche 1 bis 9, wobei die Isolatorschicht (203) dielektrisches Material, vorteilhafterweise Siliziumdioxid oder Siliziumnitrid, aufweist.

11. Elektronische Baugruppe (100) nach einem der Ansprüche 1 bis 10, wobei die Kontaktschicht (208) ein Metallelement aufweist, wobei das Metallelement vorteilhafterweise Kupfer aufweist.

12. Elektronische Baugruppe (100) nach einem der Ansprüche 1 bis 11, wobei die Baugruppe auch eine untere Kontaktschicht (208) aufweist, die auf der Rückseite (200b) eines Elementarmoduls angeordnet ist, das als unteres Modul bezeichnet wird und das erste in der Reihenfolge der Elementarmodule (200) entlang der Stapelrichtung ist, wobei die untere Kontaktschicht (208) so angeordnet ist, dass sie von der Rückseite (200b) aus die Gate-Elektrode (206) des unteren Moduls kontaktiert.

## Claims

1. Electronic assembly (100) which extends along a stacking direction from a lower surface (100a) to an upper surface (100b) coupled by a lateral surface (100c), the assembly comprises at least two elementary modules (200) stacked along the stacking direction, which each comprise, along the stacking direction and from a back side (200b) to a front side (200a), two high electron mobility transistors respectively called back transistor (202) and front transistor (201), separated by an insulator layer (203), and having in common a source electrode (204), a drain electrode (205), and a gate electrode (206), the assembly of the front and back transistors being electrically connected in parallel, the electronic assembly (100) comprises, arranged on the front side (200a) of each elementary module, a contact layer (208), electrically contacting the gate electrode (206) of the considered elementary module on its front side (200a), each of the contact layers (208) comprising an electric contact point (211) emerging onto the lateral surface.

2. Electronic assembly (100) according to claim 1, wherein a contact layer (208) interposed between two elementary modules (200), called, according to the stacking direction, first module and second module, also contacts, on the back side (200b) of the second module, the gate electrode (206) of said second module.

3. Electronic assembly (100) according to claim 1 or 2, wherein said electronic assembly (100) comprises source connection means and drain connection means arranged to connect in parallel all the front transistors and back transistors (202) .

4. Electronic assembly (100) according to claim 3, wherein the source connection means comprise source pads (209), each source pad (209) being interposed between two adjacent elementary modules to electrically connect the source electrodes of the considered elementary modules.

5. Electronic assembly (100) according to claim 3 or 4, wherein the drain connection means comprise drain pads (210), each drain pad being interposed between two adjacent elementary modules to electrically connect the drain electrodes of the considered elementary modules.

6. Electronic assembly (100) according to any of claims 1 to 5, wherein the front transistor (201) and the back transistor (202) respectively comprise a front stack and a back stack, the front stack comprising, from the insulator layer (203) to the front side (200a), a front barrier layer (201a) and a front channel layer (201b), and the back stack comprising from the insulator layer (203) to the back side (200b) a back barrier layer (202a) and a back channel layer (202b), the front channel layer and the back channel layer being each capable of forming a conduction layer (201c, 202c) in the form of a two-dimensional electron gas.

7. Electronic assembly (100) according to claim 6, wherein the front stack and the back stack are essentially identical.

8. Electronic assembly (100) according to claim 6 or 7, wherein the front and back transistors have an identical threshold voltage.

9. Electronic assembly (100) according to any of claims 6 to 8, wherein the front channel layer and the back channel layer comprise GaN and the front barrier layer and the back barrier layer comprises an AlGaN ternary alloy.

10. Electronic assembly (100) according to any of claims 1 to 9, wherein the insulator layer (203) comprises a dielectric material, advantageously, silicon dioxide or silicon nitride.

11. Electronic assembly (100) according to any of claims 1 to 10, wherein the contact layer (208) comprises a metal element, advantageously the metal element comprises copper.

12. Electronic assembly (100) according to any of claims 1 to 11, wherein said assembly also comprises a lower contact layer (208) arranged on the back side (200b) of an elementary module, called lower module, the first one in the order of the elementary modules (200) along the stacking direction, the lower contact layer (208) is arranged to contact, from the back side (200b), the gate electrode (206) of the lower module.
